# EUROPEAN PATENT SPECIFICATION

(11) **EP 2 474 043 B1**
(45) Date of publication and mention of the grant of the patent: **18.06.2014**
(21) Application number: 10811298.8
(22) Date of filing: 29.08.2010
(51) Int. Cl.: H01L 31/048, B32B 17/10

(54) **SOLAR BATTERY ASSEMBLY AND METHOD FOR FORMING THE SAME**
SOLARBATTERIEBAUGRUPPE UND VERFAHREN ZU DEREN HERSTELLUNG
ENSEMBLE BATTERIE SOLAIRE ET PROCÉDÉ DE FORMATION ASSOCIÉ

(30) Priority: 31.08.2009 CN 200910189801; 31.08.2009 CN 200920204199 U
(43) Date of publication of application: 11.07.2012
(73) Proprietor: BYD Company Limited, Shenzhen, Guangdong 518118 (CN)
(72) Inventor: LUO, Hui, Guangdong 518118 (CN)
(74) Representative: HOFFMANN EITLE
(86) International application number: PCT/CN2010/076445
(87) International publication number: WO 2011/023138

(56) References cited:
- CN-A- 1 211 828
- DE-A1- 3 239 676
- DE-A1- 19 951 444
- DE-A1-102007 037 891
- JP-A- 2001 068 703
- JP-A- 2003 243 687
- US-A1- 2005 284 516
- US-A1- 2007 052 122
- US-A1- 2008 210 361

## Description

### FIELD

The present disclosure relates to the solar battery field, in particular to a method for forming a solar battery assembly and a solar battery assembly which may be used as an automobile roof etc.

### BACKGROUND

As there is limited traditional energy reservation such as oil which has been consumed continuously along with serious pollution to the environment, utilization of wind energy and solar energy becomes popular now. Specifically, there is abundant resource of solar energy which has little geological restriction, therefore, solar energy becomes a hot and important point of the research nowadays.

Especially, new energy vehicles with little pollution to environment have become an inevitable trend for future development as it is not only environmental amicable but also less dependent on the non-renewable natural energy.

The current new energy vehicle mainly employs lithium ion battery, fuel battery or hydrogen storage battery as a power supply.

To thoroughly utilize the safe and inexhaustible solar energy, the solar batteries are now fixed on the vehicle. However, the back sheets of the solar batteries are normally flexible which is difficult to be installed on the vehicle. Besides, solar batteries may require extra space in the vehicle which may further increase the weight of the vehicle with inferior external appearance. Thus it is not widely adopted nowadays.

The current solar battery assembly is normally formed by overlapping a glass plate, a plurality of solar cells, a flexible back sheet together which are adhered together, and then the layers are heated and laminated to form the solar battery assembly.

Normally the laminated layers of glass plate, the solar cells and the flexible back plate are placed on a heating mold of a laminating machine for heating. And an elastic layer on a top cover of the laminating machine may realize the dynamic laminating of the solar battery assembly. However, the aforementioned method may have difficulty to control the laminating conditions for forming the solar battery assembly having a hard back sheet with attractive appearance and excellent performance. The elastic layer may have uneven pressure at different positions, and also because of the self weight of the flexible layer, it's difficult to ensure uniform force on the solar battery assembly to be formed. Because the back sheet is a hard one, uneven dynamic pressure may cause kinds of problems such as breaking of the solar cells, uneven binding agent caused by uneven pressure, gas bubble residues and so on. However, the solar battery assembly has demanding requirement for air-tightness. The existence of bubbles or uneven thickness of the binding agent or apertures etc. may affect the performance of the solar battery seriously. Especially for the current solar battery for vehicles, which normally has an arched shape, not only the performance requirement may become stricter, but also the laminating process renders difficulty. Recent research has disclosed that the assembly may be placed on a heating plate of an arched shaped mold, and a flexible layer is adopted for laminating, however, only certain shaped solar battery assembly may be prepared due to the restriction of the mold.

Also the efficiency may be low and the cost may be high, so it is not beneficial for large scale production. For the solar battery assembly with hard back sheet, the mold may need to be well attached with the back sheet, meanwhile the temperature of the heating plate needs to be stable which is difficult to realize. Moreover, the laminating result may not be ideal, problems such as bubble, uneven thickness of the binding agent therebetween may still exist. The solar battery assembly may not meet industrial application demand and also the yield rate thereof may be low.

WO 2009/021475 relates to a method for the production of a curved glass cover or fixed glass element for a vehicle roof, wherein in the course of the process a flat first glass pane is coated with an electric functional layer or a multiple layer coating, which has at least one electric functional layer, and the first glass pane is glued or laminated by means of an adhesive onto the side facing one vehicle interior side of a convex second glass pane.

US 2005/284516 concerns solar modules, with the properties of laminated safety glass, comprising a laminate containing a) a glass pane b) at least one solar cell unit that is located between two PVB-based films, and c) a rear covering and at least one of the PVB-based films has a tensile strength of at least 16 N/mm², are suitable for use as a facade component, roof surface, winter garden covering, soundproofing wall, or as a component of windows.

US 2008/210361 relates to a method for production of a curved screen arrangement for a vehicle, whereby a plastic film is applied to a curved glass plate by means of a die to form a film composite. The film composite is subsequently subjected to a thermal treatment at a pressure below that of atmospheric pressure in order to laminate the plastic film to the screen.

DE 3239676 is directed to an embedding process for solar generators such as those used in the terrestrial region. The interconnected solar cells are placed between hot-melt adhesive films and provided with protective coverings on both sides. To achieve an increase in the production capacity without additional engineering expenditure, a hot-melt adhesive strip is placed in the peripheral region of the composite and a closed ring made of an elastic material is placed around the edges. The closed ring encloses a cavity, its lips rest on the coverings and it is evacuated via a nozzle. Said composite is subjected to a heat treatment at a predetermined speed and at a predetermined temperature

DE 19951444 describes composite safety plate, which comprises a plasticizer containing partially acetylated polyvinylalcohol layer sandwiched between at least two glass plates, made in an autoclave-free process.

### SUMMARY

The present disclosure is directed to solve at least one of the following problems existing in the prior art such as bubbles in the solar battery assembly, solar cell fragments, uneven binding agent and low performance and yield rate caused by the aforementioned deficiencies. Accordingly, a method for forming solar battery assembly that may ensure the performance and yield rate of the solar battery assembly with a hard back sheet, also the solar battery assembly manufactured therefrom may have better performance and higher production efficiency.

According to an embodiment of the present disclosure, a method for forming a solar battery assembly may be provided, comprising the following steps:
a) performing cold vacuuming at a temperature of about 0-50°C and hot vacuuming at a temperature of about 50-200°C to a glass plate, a pfuratity of solar cells and a back sheet laminated in turn and adhered together; and
b) treating the laminated glass plate, the plurality of solar cells and the back sheet obtained in step (a) with a temperature of about 100-200°C and a pressure of about 0.5~1.5 MPa to obtain the solar battery assembly,
wherein the cold vacuuming and hot vacuuming are performed by enveloping a sealing sleeve formed with apertures around peripheries of the laminated glass plate, the plurality of solar cells and the back sheet so that the solar battery assembly is performed with hot and cold vacuuming via the apertures.

The inventor unexpectedly found that the solar battery assembly formed by employing the above mentioned method which is different from those methods in the art may decrease the occurrence such as bubbles, solar cell fragments, or uneven binding agent and so on. The yield rate may be high and also the solar battery assembly thus manufactured may have better appearance and mechanical performance. The consistency of matching between the layers in the solar battery assembly may be ensured so that the solar battery may meet the requirements of actual industrial development.

The present disclosure may adopt the non-contact static laminating process with high pressure. Preferably, the gas static laminating method may be adopted which may be more gentle and easy to locate according to the shape of the solar battery assembly. Also the solar cells may not be fragmented easily. By increasing the pressure on two surfaces of the solar battery assembly, the internal and external pressure differences may be increased, so that the laminating process may be thorough, and a small amount of fog-like bubbles may be easily absorbed by the binding agent. Thus the occurrence of bubbles in the solar battery assembly may be decreased and the effect of micro bubbles to the performance of the solar battery may be avoided. Therefore, the method according to the present disclosure may provide solar batteries with a hard back sheet with enhanced appearance and extended applicability

Especially, the method according to the present disclosure may solve the problem of difficult laminating for the current solar battery assembly with an arched shape. The method of forming the same may be simpler and easier to realize, and also the manufacturing cost thereof is reduced to a great extent. Moreover, the solar battery assembly with various shapes may be formed without needing different molds. Meanwhile, the arched solar battery assembly thus formed may have enhanced appearance with improved performance, without solar cell fragments.

And in the case that an electrode circuit and a diode protection circuit are laid inside the solar battery assembly for laminating, the method according to the present disclosure may have higher application value. Otherwise, the solar battery assembly with electronics laid inside may require more complex processes, since the electronic components such as diode etc. may be fragile and easily broken. In addition, there may be relative movement of the solar cells inside the solar battery assembly under dynamic pressure in prior art which may damage the circuit and the diode greatly and further affect the battery performance. However, the present disclosure may provide a method of non-touch static laminating based on the original shape of the solar battery assembly. Due to the uniformity of the gas pressure applied, the relative movement may not occur easily. In addition, the present method is suitable for large scale production.

The method of the present invention may be used for providing a solar battery assembly The solar battery assembly may be used as an automobile roof etc., which may comprise an arched light transmitting upper cover plate, an arched back sheet, a plurality of solar cells disposed between the arched light transmitting upper cover plate and the arched back sheet. The arched light transmitting upper cover plate, the arched back sheet and the plurality of the solar cells may be adhered together by filling binding agent between the upper cover plate and the back sheet.

The arched lower back sheet may employ one with a mohs hardness greater than 1.

The solar battery assembly used as an automobile roof may be provided on an automobile easily to receive external light and power the vehicle accordingly. And it may further decrease the total weight of the vehicle.

Additional aspects and advantages of the embodiments of present invention will be given in part in the following descriptions, become apparent in part from the following descriptions, or be learned from the practice of the embodiments present invention.

### BRIEF DESCRIPTION OF THE DRAWINGS

These and other aspects and advantages of the invention will become apparent and more readily appreciated from the following descriptions taken in conjunction with the drawings in which:

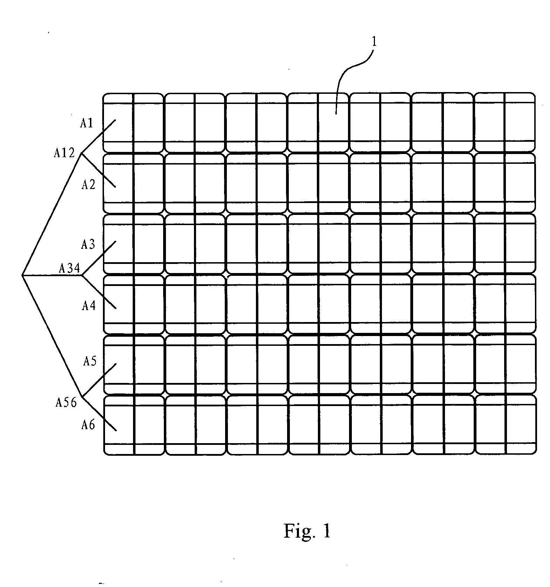

Fig. 1 is a plan view of a solar battery array according to an embodiment of the present disclosure.

### DETAILED DESCRIPTION OF THE EMBODIMENTS

The aforementioned features and advantages of the present disclosure as well as the additional features and advantages thereof will be further clearly understood hereafter as a result of a detailed description of the following embodiments.

The present disclosure may provide a method for forming a solar battery assembly which may be easily performed and ensure the mechanical performance and yield rate of the solar battery assembly, also the prepared solar battery assembly may possess more attractive appearance and enhanced mechanical performance, also the producing efficiency may be increased.

According to an embodiment of the present disclosure, the method may comprise the following steps:
a) performing cold vacuuming at a temperature of about 0~50°C and hot vacuuming at a temperature of about 50~20°C to a glass plate, a plurality of solar cells and a back sheet laminated in turn and adhered together; and
b) treating the laminated glass plate, the plurality of solar cells and the back sheet obtained in step (a) with a temperature of about 100-200°C and a pressure of about 0.5~1.5 MPa to obtain the solar battery assembly,
wherein the cold vacuuming and hot vacuuming are performed by enveloping a sealing sleeve formed with apertures around peripheries of the laminated glass plate, the plurality of solar cells and the back sheet so that the solar battery assembly is performed with hot and cold vacuuming via the apertures.

The above mentioned method is different from the prior contact dynamic laminating method which may inhibit bubble occurrence therein during encapsulating with enhanced external appearance, especially for the solar battery assembly with a hard back sheet. The difficulty for laminating a solar battery assembly with an arched shape may be overcome. Particularly, solar battery components with different shapes may be obtained to meet the demand without the need for different molds. And the solar battery assembly with the arched shape thus formed may have better appearance.

According to a preferred embodiment, the cold vacuuming temperature may be about 20-30°C for a time period of about 10~15 min, the pressure decreasing speed may be 90-100 KPa/min, and the vacuuming degree may be -54~101 KPa. More preferably, the hot vacuuming is the one performed by multistage during which the temperature may be substantially the same or not. By dividing heating time in a plurality of stages to perform the vacuuming, the bubbles in the solar battery assembly may be expelled to a greater extent.

According to the present invention, the laminated glass plate, the plurality of the solar cells and the hard back sheet may be placed in the vacuuming chamber to perform the vacuuming. According to a preferred embodiment, a sealing member, such as an encapsulating cover, formed with apertures is provided around edges of the solar battery assembly, and then vacuuming may be performed via the apertures accordingly. And the vacuuming speed may be enhanced. Especially, the method may effectively decrease the bubbles in the solar battery assembly without other negative effect to the solar battery assembly. Further, comparing with the existing vacuuming method in which the vacuuming process is not viewable, the above mentioned method may provide a solution for a secondary vacuuming or analysis if there is a problem, and it is beneficial for controlling the quality for each step and increase the quality of the final assembly. The device may also be simpler.

According to a preferred embodiment, the step (b) may comprise a step of placing the vacuumed solar battery assembly obtained in step (a) into a reactor in which the temperature and pressure are increased, maintained for a predetermined time and decreased respectively. The temperature and pressure of the reactor may be increased in multi-stage. For example, before reaching a desired high temperature and high pressure, the solar battery assembly may need to perform a plurality of stages of lower temperature and lower pressure treatment. The lower temperature and pressure may be maintained for several minutes, such as 3-5 minutes, so that the high temperature and high pressure treatment may be optimized. According to a preferred embodiment, the starting temperature for increasing the temperature may be 20-30°C, and the starting pressure for increasing the pressure may be 0-0.1 MPa, more preferably, the starting pressure thereof may be 0.1 MPa. The terminating or ending temperature for the temperature and pressure decreasing step may be 50~30°C, the terminating or ending pressure may be 0-0.1 MPa, so that the binding agent may be cured accordingly.

According to an embodiment of the present disclosure, the temperature increasing speed in the reactor may be about 1~50°C/min, the pressure increasing speed in the reactor may be about 0.01-0.2 MPa/min, the temperature decreasing speed in the reactor may be about 1~50°C/min, the pressure decreasing speed in the reactor may be about 0.01-0.2 MPa/min. According to a preferred embodiment, the high temperature and high pressure treatment may be about 130~160°C, the pressure may be about 1.0~1.5 MPa, the time may be 5~120 min, more preferably about 40-55 min. By optimizing the temperature and the pressure, the solar battery assembly may be improved without problems such as solar cell fragments etc.

The glass plate may be any light transmitting one, for example tempered glass. The back sheet may be any back sheet known in the art, for example a glass plate, a steel plate and so on which may increase the strength of the solar battery and improve the protection of core components in the solar cell so that the solar battery assembly may have an prolonged lifespan. And the method according to the present disclosure may be more obvious and suitable, also high strength may help to enhance the pressure difference between the two surfaces of the solar battery assembly under high temperature and high pressure, so it is beneficial to the final design of the solar battery assembly. According to a preferred embodiment, the back sheet may be glass plate, the double glass layers may realize better attachment and eliminate bubbles inside the solar battery assembly and improve the performance of the solar battery assembly accordingly.

The method according to the present disclosure may have more obvious effect and value for solar batteries having arched shapes. For example, the glass plate may have a predetermined curvature. The solar cell may be any known in the art. It may be single solar cell or a plurality of solar cells connected in parallel. For the solar battery having the arched shape to be used in a vehicle, a plurality of small solar cells may be assembled to form the desired arched shape.

According to an embodiment of the present disclosure, the binding agent for laminating the glass plate, the plurality of solar cells and the back sheet may be EVA film or PVB film, preferably PVB. The thickness of the binding agent being applied may be about 0.15-1.5 mm, preferably 0.76 mm. In this case, the size and strength of the battery assembly may be optimized and fragments of solar cells may be avoided. Especially, for solar battery assemblies with the glass plate used as the back sheet, the PVB film may be a half transparent film without impurities and the surface is smooth and also has certain roughness and flexibility. The PVB film possesses excellent attaching force with inorganic glass. Further, the PVB film may be transparent, heat-resistant, cold-resistant, and wet-resistant, and also possesses excellent mechanical strength with superior attachability and light transparency.

The solar cell may comprise electrodes for extracting current, preferably the electrode may be connected with the back sheet to achieve better connection. The connection may be achieved by welding. A PCB board may be arranged under the arched lower back sheet, or the lower hard back sheet may be printed with metal slurry and then sintered to form the desired electrodes. For example, the welding points of the welding strips, the connecting circuit and the diode, wire welding points and so on may be arranged on the surface of the back sheet and finally extracting a bus line to supply power for the vehicle. The power current and voltage and so on may be adjusted, meanwhile the solar cells may be fixed stably, the vibration from the vehicle may not affect the solar battery assembly used as the automobile roof. The solar battery assembly may have a prolonged lifespan and also the automobile roof may be maintainable.

According to a preferred embodiment of the present disclosure, a series or a parallel circuit having a voltage lower than 14 V may be employed. The circuit having a lower voltage may not cause breakdown of the solar cells under the hot spot effect caused by the sunlight shadow, and certain part of the solar cells under the shadow of the sunlight may receive extra heat which may further cause reverse breakdown, so that the reliability of the solar battery assembly may be increased. To solve the hot spot effect, preferably, a bypass diode or bypass diodes may be connected in anti-parallel with the solar battery array formed by solar cells to protect the solar cells inside the solar battery assembly. The bypass diode may be connected in parallel with the current extracting line outside the solar battery assembly or within the solar battery assembly, for example, within the space between the solar cells. By placing the circuits and diodes on the upper surface of the back sheet, Problems such as complex wire layout, short circuits or open circuit caused by dropping off of the wires may be avoided accordingly, so that the reliability of the solar battery assembly is enhanced. To increase the lifespan, the electrical components may be coated with adhesives or mantled with water-resistant shell to further enhance the battery performance.

The present disclosure may further provide solar battery assembly formed according to the method as describe above, which may serve as an automobile roof. And the automobile roof formed by the solar battery assembly may receive the sunlight and generate energy with an improved external appearance. The solar battery assembly may comprise an arched light transmitting upper cover plate, an arched back sheet, a plurality of solar cells disposed between the arched light transmitting upper cover plate and the arched back sheet. The arched light transmitting upper cover plate, the arched back sheet and the plurality of the solar cells are adhered together by filling binding agent between the upper cover plate and the back sheet.

According to the present disclosure, the curvatures of the light transmitting upper cover plate and the back sheet having arched shapes may be adjusted according to practical requirements. According to an embodiment of the present disclosure, curvatures of the light transmitting upper cover plate and the back sheet having arched shapes may be consistent with each other. Preferably, the largest distance between the upper board and the lower board after attaching may be less than 5 mm. By optimizing the attaching degree between the arched light transmitting upper cover plate and the arched hard back sheet, the vacuuming process may be even with improved gas exhaustion.

According to a preferred embodiment of the present disclosure, the lower surface of the arched back sheet may be coated with ink to adjust the background color of the automobile roof to improve the external appearance and light absorption rate thereof.

The front and back surfaces of the solar cell may be welded by welding strips for extracting negative and positive currents, and a plurality of the solar cells are connected in series, in parallel or in series and parallel by attaching the welding strips with the related electrode grid lines on the front and back surface of the solar cell. According to a preferred embodiment, an adhesive tapes are attached to a surface of the welding strip and current collecting strips for extracting the current respectively, so that the appearance of the solar battery assembly may be improved with enhanced applicability.

According to a preferred embodiment, a thin film solar cell may be used instead of the solar cells described hereinbefore with a preferable mohs hardness greater than 1. Preferably, the arched thin film solar cell may be obtained by coating a thin solar film onto a glass plate having an arch shape, i.e., coating the thin solar film onto the arched glass plate which may serve as the automobile roof via PVD (physical vapor deposition), so that the cost may be saved dramatically. While thin film solar cell is adopted, an arched glass plate with various kinds of shapes according to practical requirements may be adopted to finalize the design of the thin solar cell film and the solar cell respectively.

According to another embodiment of the present disclosure, binding forces between the arched upper cover plate and the solar cells and between the solar cells and the arched back sheet may be greater than 5N/cm, so that there may be less or no bubbles in the obtained automobile roof, the appearance and the electro-chemical performance may be high.

According to some embodiments of the present disclosure, a sealing member, such as a sealing adhesive tape, may be provided around edges of the solar battery assembly which may serve as an automobile roof, and a sealing agent may be disposed between the sealing adhesive tape and the solar battery assembly to achieve sealing, water-proof, dust-proof performance. Also, during actual use, environmental factors may have less impact on the performance and lifespan of the solar battery assembly serving as the automobile roof. According to a preferred embodiment of the present disclosure, sealing agent may be filled between the sealing member and the solar battery assembly. Further, a groove may be formed on a side of the sealing member facing toward the solar battery assembly to accommodate the edges of the solar battery assembly, and the sealing agent may be filled inside the groove and joined with the edges of the solar battery assembly serving as the automobile roof so as to achieve more tight sealing and avoid loosening of the sealing tape during vibration of the vehicle. The sealing performance thereof may be enhanced, resulting in enhanced electro-chemical performance and prolonged lifespan. It should be noted that the sealing agent or adhesive may be any known in the art, for example, silica gel, epoxy resin and so on.

According to an embodiment of the present disclosure, the solar battery assembly serving as the automobile roof may have a simplified structure, which is easy for industrialization. Further, the appearance thereof is enhanced with extended applicability.

In the following, the present invention will be described in conjunction with embodiments.

### Embodiment 1

Fig. is a plan view of a solar battery array according to an embodiment of the present disclosure. The solar battery array formed by 6 lines of two series × three parallel (2S3P) connected solar cells (84 in total) designated by 1 was placed between an arched glass transparent upper plate having an arc rise of about 20 mm, a size of about 1115 mm × 998 mm and a thickness of about 2.0 mm and an arched glass back sheet having an arc rise of about 20 mm, a size of about 1115 mm × 998 mm and a thickness of about 1.6 mm. As shown in Fig. 1, the solar cells 1 was connected in series. And the first and second lines A1, A2, the third and fourth lines A3, A4, and the fifth and sixth lines A5, A6 was connected in series respectively whereas the connected line A12, A34 and A56 was connected in parallel. Each solar cell had a size of about 125 mm × 62.5 mm and a designed voltage of about 14 V The spacing between the solar cells was about 2 mm. The solar battery array had a size of about 961 mm × 820 mm. A layer of PVB film with a thickness of about 0.76 mm was disposed between the arched glass transparent upper plate and the solar cells or between the solar cells and the arched glass back sheet. The three layers were laminated successively and encapsulated around the edges with a rubber sealing cover formed with apertures. The rubber cover was vacuumed via the apertures at a speed of about 10 KPa/min for about 10 min with a vacuum degree of about -101 KPa. Then the solar battery assembly was hot vacuumed for 8 stages. The temperature and the maintained time for each stage were respectively about 90°C for 225 s; about 95°C for 255 s; about 100°C for 300 s; about 105°C for 300 s; about 110°C for 300 s; about 115°C for 300 s; about 120°C for 315 s; and about 125°C for 315 s. The vacuum degree was about -100~100 KPa. Then the solar battery assembly was placed into a container for increasing the temperature and the pressure by three stages. In the first stage, the temperature was about 90°C, and the pressure was increased to about 0.1 MPa, which are maintained for 9-10 min. In the second stage, the temperature was about 90°C, and the pressure was 0.1 MPa, which are maintained for 3-4 min. In the third stage, the temperature was increased to about 150°C, and the pressure was increased to about 1.2 MPa with a whole processing time of about 45 min. After that, high temperature and high pressure treatment was performed, and then the temperature and the pressure are decreased. The high temperature and high pressure treatment was performed at a temperature of about 140~158°C under a pressure of about 1.2 MPa for about 40-50 min. During decreasing the temperature and the pressure, the temperature and the pressure were decreased at a constant speed to about 30°C and about 0.1 MPa within about 40-45 min respectively.

Electrodes were led out after obtaining the solar battery assembly. And further treatment such as coating with silica gel for encapsulation is performed for forming the solar battery assembly. In the solar battery assembly, there are no bubbles, fogs or microbubbles, and there are no fragments of the solar cells yet. Further, the adhesion between the upper plate and the back sheet is excellent, resulting in a solar battery assembly with an efficiency of about 16.5%.

### Embodiment 2

The solar battery assembly in Embodiment 2 is obtained according to the method described in Embodiment 1, with the exception that the pressure for high temperature and high pressure treatment was about 1.5 MPa. In the solar battery assembly, there are no bubbles, fogs or microbubbles, and there are no fragments of the solar cells yet. Further, the adhesion between the upper plate and the back sheet is excellent, resulting in a solar battery assembly with an efficiency of about 15.5%.

### Embodiment 3

The solar battery assembly in Embodiment 3 is obtained according to the method described in Embodiment 1, with the exception that the pressure for high temperature and high pressure treatment was about 0.5 MPa. In the solar battery assembly, there are no bubbles, fogs or microbubbles, and there are no fragments of the solar cells yet. Further, the adhesion between the upper plate and the back sheet is excellent, resulting in a solar battery assembly with an efficiency of about 14%.

### Comparative embodiment 1

A solar battery array formed by 6 lines of two series × three parallel (2S3P) connected solar cells (totally 84 PCS) was placed between an arched glass transparent upper plate having an arc rise of about 20 mm, a size of about 1115 mm × 998 mm and a thickness of about 2.0 mm and an arched glass back sheet with an arc rise of about 20 mm, a size of about 1115 mm × 998 mm and a thickness of about 1.6 mm. Each solar cell had a size of about 125 mm × 62.5 mm and a designed voltage of about 14 V. The spacing between the solar cells was about 2 mm. The solar battery array had a size of about 961 mm × 820 mm. A layer of PVB film with a thickness of about 0.76 mm was disposed between the arched glass transparent upper plate and the solar cells or between the solar cells and the arched glass back sheet. The three layers were laminated successively in a laminating machine which was vacuumed for about 20 min. The assembly was heated to about 140°C for about 50 min. The glass plate was cracked during processing and the preparation of the solar battery assembly fails.

The solar battery assembly formed according to the method in the present disclosure may have excellent appearance and mechanical performance, which may be easily industrialized, especially for forming a solar battery assembly with an arched hard back sheet. Thus, the solar battery assembly formed with the arched hard back sheet may have wider applicability.

## Claims

1. A method for forming a solar battery assembly, comprising the following steps:
a) performing cold vacuuming at a temperature of about 0~50°C and hot vacuuming at a temperature of about 50~200 °C to a glass plate, a plurality of solar cells and a back sheet laminated in turn and adhered together; and
b) treating the laminated glass plate, the plurality of solar cells and the back sheet obtained in step (a) with a temperature of about 100-200°C and a pressure of about 0.5~1.5 MPa to obtain the solar battery assembly,
wherein the cold vacuuming and hot vacuuming are performed by enveloping a sealing sleeve formed with apertures around peripheries of the laminated glass plate, the plurality of solar cells and the back sheet so that the solar battery assembly is performed with hot and cold vacuuming via the apertures.

2. The method according to claim 1, wherein the cold vacuuming is performed at a temperature of about 20-30°C for about 10-15 min with a pressure decreasing speed of about 90~100 KPa/min and a vacuum degree of about -50~-101 KPa.

3. The method according to claim 1, wherein the hot vacuuming is performed at a temperature of about 90~110°C for about 10-120 min with a vacuum degree of about -50~-101 KPa, wherein the hot vacuuming is preferably vacuuming by heating in multistage.

4. The method according to claim 1, wherein the step (b) further comprises the steps of:
placing the vacuumed solar battery assembly obtained in step (a) into a reactor in which the temperature and pressure are increased, maintained for a predetermined time and decreased respectively; and
increasing the temperature and the pressure in the reactor in multistage with an initial temperature of 20-30 degrees and an initial pressure of about 0-0.1 MPa, and the temperature and the pressure in the reactor are decreased with an ending temperature of about 50-30 degrees and an ending pressure of about 0-0.1 MPa, wherein the temperature and the pressure in the reactor preferably are increased by a temperature increasing rate of about 1~50°C/min and a pressure increasing speed of about 0.01-0.2 MPa/min, and the temperature and the pressure in the reactor preferably is decreased by a temperature decreasing speed of about 1~50°C/min and a pressure decreasing speed of about 0.01-0.2 MPa/min respectively.

5. The method according to claim 1, wherein the laminated glass plate, the plurality of solar cells and the back sheet obtained in step (a) are treated with a temperature of about 130-160°C and a pressure of about 1~1.5 MPa for about 5-120 min.

6. The method according to claim 1, wherein the glass and the back sheet have an arched shape respectively, and the back sheet is a glass plate.

7. The method according to claim 1, wherein the glass plate, the plurality of the solar cells and the back sheet are adhered by polyvinyl butyral resin or polyethylene vinyl acetate with a thickness of about 0.15~1.5 mm.

8. The method according to claim 1, wherein the solar cell comprises extracting electrodes for extracting current, and the extracting electrodes are welded to the back sheet with a bypass diode connected the solar cell in anti-parallel.

## Patentansprüche

1. Verfahren zum Bilden eines Solarbatterie-Aufbaus, das die folgenden Schritte umfasst:
a) Durchführen einer Kaltvakuumbehandlung bei einer Temperatur von etwa 0 bis 50°C und einer Heißvakuumbehandlung bei einer Temperatur von etwa 50 bis 200°C mit einer Glasplatte, einer Mehrzahl von Solarzellen und einer Rückseitenlage, die der Reihe nach laminiert sind und aneinander haften; und
b) Behandeln der in Schritt (a) erhaltenen laminierten Glasplatte, der Mehrzahl von Solarzellen und der Rückseitenlage mit einer Temperatur von etwa 100 bis 200°C und einem Druck von etwa 0,5 bis 1,5 MPa, um den Solarbatterie-Aufbau zu erhalten,
worin die Kaltvakuumbehandlung und die Heißvakuumbehandlung durch Einhüllen in eine versiegelnde Manschette, die mit Öffnungen um den Umfang der laminierten Glasplatte, der Mehrzahl von Solarzellen und der Rückseitenlage herum gebildet ist, um die Heiß- und Kaltvakuumbehandlung des Solarbatterie-Aufbaus durch die Öffnungen durchzuführen.

2. Verfahren gemäß Anspruch 1, worin die
Kaltvakuumbehandlung bei einer Temperatur von etwa 20 bis 30°C über etwa 10 bis 15 Minuten mit einer Druckverringerungsgeschwindigkeit von etwa 90 bis 100 KPa/Min. und einem Vakuumgrad von etwa -50 bis -101 KPa durchgeführt wird.

3. Verfahren gemäß Anspruch 1, worin die
Heißvakuumbehandlung bei einer Temperatur von etwa 90 bis 110°C über etwa 10 bis 120 Minuten bei einem Vakuumgrad von etwa -50 bis -101 KPa durchgeführt wird,
wobei die Heißvakuumbehandlung vorzugsweise eine Vakuumbehandlung mit Erwärmung in mehreren Stufen ist.

4. Verfahren gemäß Anspruch 1, worin Schritt (b) weiterhin die folgenden Schritte umfasst:
Platzieren des in Schritt (a) erhaltenen vakuumbehandelten Solarbatterie-Aufbaus in einen Reaktor, in dem die Temperatur unter Druck erhöht werden, für eine vorbestimmte Zeit gehalten werden bzw. verringert werden; und
Erhöhen der Temperatur und des Drucks im Reaktor in mehreren Stufen mit einer Anfangstemperatur von 20 bis 30°C und einem Anfangsdruck von etwa 0 bis 0,1 MPa, und die Temperatur und der Druck im Reaktor werden zu einer Endtemperatur von etwa 50 bis 30° und einem Enddruck von etwa 0 bis 0,1 MPa verringert, worin die Temperatur und der Druck im Reaktor vorzugsweise mit einer Temperatursteigerungsrate von etwa 1 bis 50°C/min und einer Drucksteigerungsgeschwindigkeit von etwa 0,01 bis 0,2 MPa/min erhöht werden, und die Temperatur und der Druck im Reaktor vorzugsweise bei einer Temperaturverringerungsgeschwindigkeit von etwa 1 bis 50°C/min und einer Druckverringerungsgeschwindigkeit von etwa 0,01 bis 0,2 MPa/min verringert werden.

5. Verfahren gemäß Anspruch 1, worin die wie in Schritt (a) erhaltene laminierte Glasplatte, die Mehrzahl von Solarzellen und die Rückseitenlage mit einer Temperatur von etwa 130 bis 160°C und einem Druck von etwa 1 bis 1,5 MPa für etwa 5 bis 120 Minuten behandelt werden.

6. Verfahren gemäß Anspruch 1, worin das Glas und die Rückseitenlage jeweils eine gebogene Form haben, und die Rückseitenlage eine Glasplatte ist.

7. Verfahren gemäß Anspruch 1, worin die Glasplatte, die Mehrzahl von Solarzellen und die Rückseitenlage durch Polyvinylbutyralharz oder Polyethylenvinylacetatharz verklebt sind, mit einer Dicke von etwa 0,15 bis 1,5 mm.

8. Verfahren gemäß Anspruch 1, worin die Solarzelle Entnahmeelektroden zum Entnehmen von Strom umfasst, und die Entnahmeelektroden mit der Rückseitenlage verschweißt sind, mit einer Bypass-Diode, die mit der Solarzelle anti-parallel verbunden ist.

## Revendications

1. Procédé de formation d'un ensemble batterie solaire, comprenant les étapes suivantes :
a) réaliser une mise sous vide à froid à une température d'environ 0 à 50°C et une mise sous vide à chaud à une température d'environ 50 à 200°C sur une plaque de verre, une pluralité de cellules solaires et une feuille arrière stratifiées l'une après l'autre et collées ensemble ; et
b) traiter la plaque de verre stratifiée, la pluralité de cellules solaires et la feuille arrière obtenues à l'étape (a) à une température d'environ 100 à 200°C et à une pression d'environ 0,5 à 1,5 MPa afin d'obtenir l'ensemble batterie solaire,
dans lequel la mise sous vide à froid et la mise sous vide à chaud sont réalisées en enveloppant un manchon d'étanchéité doté d'ouvertures autour des périphéries de la plaque de verre stratifiée, de la pluralité de cellules solaires et de la feuille arrière de sorte que l'ensemble batterie solaire soit réalisé par mise sous vide à froid et à chaud par l'intermédiaire des ouvertures.

2. Procédé selon la revendication 1, dans lequel la mise sous vide à froid est réalisée à une température d'environ 20 à 30°C pendant environ 10 à 15 min avec une vitesse de diminution de pression d'environ 90 à 100 KPa/min et un degré de vide d'environ -50 à -101 KPa.

3. Procédé selon la revendication 1, dans lequel la mise sous vide à chaud est réalisée à une température d'environ 90 à 110°C pendant environ 10 à 120 min avec un degré de vide d'environ -50 à -101 KPa, dans lequel la mise sous vide à chaud est, de préférence, une mise sous vide par chauffage en plusieurs étapes,

4. Procédé selon la revendication 1, dans lequel l'étape (b) comprend en outre les étapes qui consistent :
à placer l'ensemble batterie solaire mis sous vide obtenu à l'étape (a) dans un réacteur dans lequel la température et la pression augmentent, sont maintenues pendant une durée prédéterminée et diminuent respectivement ; et
à augmenter la température et la pression dans le réacteur en plusieurs étapes avec une température initiale allant de 20 à 30 degrés et une pression initiale d'environ 0 à 0,1 MPa, et la température et la pression dans le réacteur diminuent pour atteindre une température finale d'environ 50 à 30 degrés et une pression finale d'environ 0 à 0,1 MPa, où la température et la pression dans le réacteur, de préférence, augmentent par un taux d'augmentation de température d'environ 1 à 50°C/min et par une vitesse d'augmentation de pression d'environ 0,01 à 0,2 MPa/min, et la température et la pression dans le réacteur, de préférence, diminuent par une vitesse de diminution de température d'environ 1 à 50°C/min et par une vitesse de réduction de pression d'environ 0,01 à 0,2 MPa/min, respectivement.

5. Procédé selon la revendication 1, dans lequel la plaque de verre stratifiée, la pluralité de cellules solaires et la feuille arrière obtenues à l'étape (a) sont traitées à une température d'environ 130 à 160°C et à une pression d'environ 1 à 1,5 MPa pendant environ 5 à 120 min.

6. Procédé selon la revendication 1, dans lequel le verre et la feuille arrière présentent une forme arquée respectivement, et la feuille arrière est une plaque de verre.

7. Procédé selon la revendication 1, dans lequel la plaque de verre, la pluralité de cellules solaires et la feuille arrière sont collées par une résine butyral-polyvinylique ou par un polyéthylène acétate de vinyle avec une épaisseur d'environ 0,15 à 1,5 mm.

8. Procédé selon la revendication 1, dans lequel la cellule solaire comprend des électrodes d'extraction destinées à l'extraction du courant, et les électrodes d'extraction sont soudées à la feuille arrière avec une diode de dérivation connectée à la cellule solaire en anti-parallèle.
